# EUROPEAN PATENT APPLICATION

(11) **EP 4 626 159 A1**
(43) Date of publication of application: **01.10.2025**
(21) Application number: 24166379.8
(22) Date of filing: 26.03.2024
(51) Int. Cl.: H05K 7/20, H01L 23/473, H02M 7/00

(54) **POWER CONVERTER UNIT**

(71) Applicant: Koenigsegg Automotive AB, 262 74 Ängelholm (SE)
(72) Inventor: von KOENIGSEGG, Christian, 266 54 VEJBYSTRAND (SE); ERLANDSSON, Valdemar, 302 94 HALMSTAD (SE)
(74) Representative: Brann AB

(57) **Abstract**

A power converter unit (10) is proposed that has a support structure (12), a first transistor arrangement (14), and a first capacitor arrangement (16). The support structure (12) is arranged to at least partly support the first transistor arrangement (14) and the first capacitor arrangement. The support structure (12) has a first wall (18), and the first transistor arrangement (14) and the first capacitor arrangement (16) are located on opposite sides of the first wall (18). The first capacitor arrangement (16) is thermally coupled to the first wall (18), and the first wall (18) forms a capacitor heatsink (20) for the first capacitor arrangement (16). The first transistor arrangement (14) comprises one or more transistor power modules (22), and each transistor power module (22) has a transistor heatsink (24). The support structure (12) has a first coolant conduit (26) at least partly formed by the first wall (18). The first coolant conduit (26) is arranged to expose the capacitor heat sink formed by the first wall (18) to a coolant and to expose the transistor heatsink (24) of each transistor power module (22) of the first transistor arrangement (14) to a coolant.

## Description

### TECHNICAL FIELD

The proposed technology generally relates to the field of power converters, and specifically to compact power inverters and/or rectifiers that forms part of a powertrain for driving a vehicle.

### BACKGROUND

A power inverter is a power electronic device that convert Direct Current (DC) to Alternating Current (AC). A power rectifier is a power electronic device that convert AC to DC. A power inverter/rectifier, is a power electronic device that can convert AC to DC, and vice versa.

Power inverters are critical components in powertrains for electric vehicles and hybrid-electric vehicles having a battery as power source and an electric motor as a prime mover. The power inverter converts DC from the battery to AC that drives the electric motor. If the powertrain instead has a power inverter/rectifier, it can also convert AC from the electric motor to DC that charges the battery, for example when breaking with the electric motor. Inverters and rectifiers are also used to step voltage up or down between the battery and the electric motor.

Power inverters are commonly based on transistors. The transistors can be arranged in transistor power modules that provide physical containment of the transistors. The transistors are typically soldered or sintered on a power-electronic substrate that carries the transistors. The substrate provides electrical contact, thermal contact, and electrical insulation where needed. Heat is generated by the transistors in operation. Power inverters commonly has capacitors to provide a more stable DC voltage for the transistors. These generate heat in operation. Typically, the heat generated by the capacitors is less than the heat generated by the transistors.

It is an object of the proposed technology to provide a power converter architecture that is compact and has an efficient cooling. It is further an object to provide a power converter architecture for high-performance applications, for example in electric or hybrid-electric vehicles, such as cars, aircraft, and boats.

### SUMMARY

In a first aspect of the proposed technology, a power converter unit comprises: a support structure, a first transistor arrangement, and a first capacitor arrangement. The support structure is arranged to at least partly support the first transistor arrangement and the first capacitor arrangement. The support structure has a first wall, and the first transistor arrangement and the first capacitor arrangement are located on opposite sides of the first wall. The first capacitor arrangement is thermally coupled to, or in thermal connection with, the first wall, and the first wall forms a capacitor heatsink for the first capacitor arrangement. The first transistor arrangement comprises one or more transistor power modules, and each transistor power module has a transistor heatsink. The support structure has a first coolant conduit at least partly formed by the first wall, and the first coolant conduit is arranged to expose the capacitor heat sink formed by the first wall to a coolant and to expose the transistor heatsink of each transistor power module of the first transistor arrangement to a coolant. The features of the proposed power converter unit jointly contribute to a compact power converter unit.

It is understood that the first coolant conduit can, or is arranged to, conduct a coolant through the support structure. It is further understood that the capacitor heat sink formed by the first wall and the transistor heatsink of each transistor power module may be exposed to the same coolant. That a structure is exposed to a coolant means that the coolant contacts the coolant. It is specified that the first wall forms a capacitor heatsink for the first capacitor arrangement. Worded differently, the first wall is arranged to function as a capacitor heatsink for the first capacitor arrangement. It is specified that the first coolant conduit is arranged to expose the capacitor heat sink to a coolant. Worded differently, the capacitor heat sink is arranged to be exposed to a coolant at a passage of the coolant through first coolant conduit, or the first coolant conduit is arranged to allow a coolant to remove heat form the capacitor heat sink at a passage of the coolant through first coolant conduit. It is specified that the first coolant conduit is arranged to expose the transistor heatsink of each transistor power module to a coolant. Worded differently, the transistor heatsink of each transistor power module is arranged to be exposed to a coolant at a passage of the coolant through first coolant conduit, or the first coolant conduit is arranged to allow a coolant to remove heat form the transistor heatsink of each transistor power module at a passage of the coolant through first coolant conduit.

A heatsink is understood as a passive heat exchanger that transfers heat generated by an electronic or a mechanical device to a fluid medium, such as air or a liquid coolant, where it is dissipated away. It is understood that the first coolant conduit is arranged to carry, or lead, a liquid coolant.

In a second aspect of the proposed technology, a powertrain comprises: a battery pack, a power converter unit according to the first aspect of the proposed technology, and an electric motor that are arranged to cooperate and supply power the powertrain. It is understood that the powertrain can be a fully electric powertrain or a hybrid-electric powertrain. For the latter, the powertrain may further comprise a combustion engine that is arranged to supply power the powertrain.

In a third aspect of the proposed technology, a vehicle comprises: a powertrain according to the second aspect of the proposed technology arranged to provide motive power to the vehicle. It is understood that the vehicle may be a car, aircraft, or a boat. For example, the powertrain may be arranged to supply the motive power to a wheel of a car or a propeller of an aircraft or boat.

The power converter unit may be a power inverter unit for converting DC to AC. Alternatively, the power converter unit may be a power rectifier unit for converting AC to DC. Alternatively, the power converter unit may be a power inverter/rectifier unit for converting DC to AC, and vice versa. It is understood that the first transistor arrangement and the first capacitor arrangement may be arranged to cooperate in the converting. The first transistor arrangement and the first capacitor arrangement may be operationally connected by electric wires and/or busbars.

The support structure may be arranged to fully support the first transistor arrangement and the first capacitor arrangement. This means that that the support structure by itself can support the first transistor arrangement and the first capacitor arrangement. It is understood that the support structure may have connecting elements, such as screws, that connects to the first transistor arrangement and the first capacitor arrangement. The power converter unit may be a static power converter unit that does not depend on moving parts in the conversion process.

It is specified that the first transistor arrangement and the first capacitor arrangement are located on opposite sides of the first wall. The first capacitor arrangement may be positioned directly opposite to the first transistor arrangement relative to the first wall. Worded differently, the first transistor arrangement and the first capacitor arrangement may be positioned abreast. The first coolant conduit may pass between the first transistor arrangement and the first capacitor arrangement. This contributes to a more compact architecture.

It is understood that the first wall is a flat structure, or that it defines a planar geometry. It is further understood that the first wall has a first wall side, or outer side, and an opposite second wall side, or inner side. It is further understood that the first wall side faces in a first direction and that the second wall side faces in an opposite second direction. The first transistor arrangement, or the transistor power modules of the first transistor arrangement, are positioned on, or at, the first wall side, and the first capacitor arrangement, or the capacitors of the first capacitor arrangement, are positioned on, or at, the second wall side.

The first transistor arrangement may be located on the first wall side of the first wall and the first capacitor arrangement may be located on the second wall side of the first wall.

For example, the first wall may be of metal, such as an aluminum alloy.

It is specified that the first transistor arrangement comprises one or more transistor power modules. The first transistor arrangement may have a plurality of transistor power modules. For example, it may have three transistor power modules. The transistor power modules may be arranged in a row.

The first transistor arrangement may be attached to, or supported by, the first wall. More specifically, each transistor power module may be attached to, or supported by, the first wall.

The transistor heatsink of each transistor power module may have protrusions extending into the first coolant conduit. The transistor heatsink of each transistor power module may have a heatsink base from which the protrusions extend. The heatsink base may define a base plane. It is understood that the protrusions are arranged to dissipate heat into the coolant and to allow passage of the coolant transverse to the protrusions. The protrusions may be fins. Alternatively, the protrusions may be pins. Each pin may have a tip. It is understood that the pin extends between the heatsink base to the tip. Each pin may define a cylindrical geometry, or it may taper from the heatsink base to the tip.

Each transistor power module may comprise a power electronics substrate and one or more transistors, wherein the one or more transistors are supported by the substrate. The substrate may enclose the one or more transistor. The substrate may support the transistor heatsink of the transistor power module. The one or more transistors may be thermally coupled to, or in thermal connection with, the transistor heatsink. The substrate may be arranged to conduct heat from the one or more transistors to the transistor heatsink. The substrate may have electric leads and electric terminals, wherein the terminals are accessible from outside the substrate and the electric leads operationally connects the terminals and the one or more transistors. The substrate may have a base structure. The base structure may be an electrically insulating ceramic base structure. The base structure may enclose, or encapsulate, the transistors. The base structure may further enclose, or encapsulate, the electric leads. The one or more transistors may be MOSFETs.

The first capacitor arrangement may comprise a plurality of capacitors. Each capacitor may be thermally coupled to, or in thermal connection with, the first wall. The capacitors may be arranged in one or more rows. Each capacitor may have a cylindrical geometry with a base side, and the capacitor may be oriented with the base side facing the first wall. Each capacitor may have terminals, or more specifically a pair of terminals. It is understood that a capacitor can be charged and discharge via its terminals. Each capacitor may be a radial-style capacitor with the terminals, such as solder terminals, positioned at the base side.

Each capacitor may be a film capacitor, or more specifically a high-voltage film capacitor. The first capacitor arrangement may have a combined capacitance in the range 100 to 500 pF, or 200 to 400 µF.

The first capacitor arrangement may comprise a busbar arrangement located between the capacitor arrangement, or the capacitors, and the first wall. It is understood that the busbar arrangement may extend from between the capacitors and the first wall, for example to allow the busbar arrangement to be connected in a circuit. The first transistor arrangement and the first capacitor arrangement may be operationally coupled via the busbar arrangement. The capacitors may be operationally coupled by the busbar arrangement, for example to jointly function as a single capacitor, such as in a parallel circuit. It is understood that the terminals of each capacitor may be attached to the busbar arrangement, for example by soldering.

The first capacitor arrangement, the capacitors, or the terminals of the capacitors may be thermally coupled to, or in thermal connection with, the busbar arrangement. The busbar arrangement may be thermally coupled to, or in thermal connection with, the first wall, or more precisely the capacitor heatsink formed by the first wall. Worded differently, the first capacitor arrangement, the capacitors, or the terminals of the capacitors may be thermally coupled to, or in thermal connection with, the first wall, or more precisely the capacitor heatsink formed by the first wall, via the busbar arrangement.

The busbar arrangement may be a flat structure, or it may define, or outline, a planar geometry between the capacitor arrangement and the first wall, or at the capacitors. The busbar arrangement may be located between the capacitors and the first wall. The busbar arrangement may be aligned with, or parallel with, the first wall. Worded differently, the busbar arrangement may be transverse to the abovementioned second direction. The busbar arrangement may comprise, or be composed of, one or more flat busbars. For example, the busbar may be of metal sheets, such as copper sheets.

The capacitors may be supported by the busbar arrangement, and the busbar arrangement may be supported by the support structure.

It is specified that the first capacitor arrangement is thermally coupled to the first wall. The power converter unit may further comprise a first thermal conductor arranged to conduct heat from the first capacitor arrangement to the first wall, or more precisely to the capacitor heatsink formed by the first wall. More specifically, the first thermal conductor may be arranged to conduct heat from the busbar arrangement of the first capacitor arrangement. Worded differently, the first capacitor arrangement, or the busbar of the first capacitor arrangement, may be thermally coupled to, or in thermal connection with, the first wall, or more precisely the capacitor heatsink formed by the first wall, via the first thermal conductor. It is understood that the first thermal conductor contacts the first wall and the first capacitor arrangement, or the busbar arrangement of the first capacitor arrangement. A first thermal conductor is understood as a structure that allows heat to be transferred within the structure.

The first thermal conductor may be located between the capacitor arrangement and the first wall. More specifically, it may be located between the busbar arrangement and the first wall. The first thermal conductor may fill, or partly fill, a space formed between the first capacitor arrangement and the first wall, or more precisely between the busbar arrangement and the first wall. The first thermal conductor may be a flat, or it may define a planar geometry. The first thermal conductor may be aligned with, or parallel with, the first wall. Worded differently, the first thermal conductor may be transverse to the abovementioned second direction.

The first thermal conductor may be of a thermal interface material, which is understood as a material that is inserted between two components to enhance the thermal coupling between them. For example, the first thermal conductor may comprise a thermal pad, a thermal paste, and/or a curable thermal gap filler.

Additionally or alternatively to the first thermal conductor, the first capacitor arrangement, or more precisely the busbar arrangement, may be thermally coupled directly to, or in direct thermal connection with, the first wall, or more precisely the capacitor heatsink formed by the first wall. For example, the first capacitor arrangement, or the busbar arrangement, may be in direct contact with the first wall, or the capacitor heatsink.

The first coolant conduit may have a first conduit section, one or more second conduit sections, and a third conduit section, wherein each of the second conduit sections connects the first conduit section and the third conduit section. Worded differently, the second conduit sections are connected in parallel to the first conduit section and the third conduit section.

The first coolant conduit may be arranged to lead the coolant through the first conduit section in a first flow direction. The first coolant conduit may be arranged to lead the coolant through the one or more second conduit section in a second flow direction. The first coolant conduit may be arranged to lead the coolant through the third conduit section in a third flow direction.

The first conduit section and the second conduit section may extend in parallel within the first wall. The first flow direction and the third flow direction may be parallel. The first flow direction and the third flow direction may be opposite. This allows for an inlet and an outlet for the coolant to be located on the same side of the support structure. The first flow direction and the third flow direction may be the same. This allows for an inlet and an outlet for the coolant to be located on opposite sides of the support structure. Worded differently, the power converter unit may have an inlet for receiving a coolant and an outlet for dispelling the coolant, wherein the first conduit section is coupled to the inlet and the third conduit section is coupled to the outlet, or vice versa. The inlet and the outlet may be located on the same side of the support structure. Alternatively, the inlet and the outlet may be located on opposite sides of the support structure.

The second flow direction may be transverse to the first flow direction and/or the second flow direction. It is specified above that the first coolant conduit may have a plurality of second conduit sections. The second flow direction may then the same, or parallel, in each of the second conduit sections. This contributes to a more compact power converter unit.

The first conduit section may pass between the first a first transistor arrangement and the first capacitor arrangement. This contributes to a more compact power converter unit. It is specified that the first transistor arrangement may have a plurality of transistor power modules that are arranged in a row. The row of transistor power modules may be aligned with the first conduit section, or the first flow direction. Worded differently, the plurality of transistor power modules may be lined up along the first conduit section. It is specified that the first capacitor arrangement may comprise a plurality of capacitors that arranged in one or more rows. The one or more rows of capacitors may be aligned with the first conduit section, or the first flow direction. Worded differently, the plurality of capacitors may be lined up along the first conduit section. The architectures described here contributes to a more compact power converter, in particular if it has a rectangular cuboid shape.

The complete first conduit section may be formed by the first wall. It is specified that the first wall is a flat structure. The first conduit section may be elongated in the first flow direction. The first conduit section may be flattened congruently with the first wall. More specifically, the first coolant conduit may have a mean height and a mean width transverse to the first flow direction, wherein the mean height is aligned with the first wall side and/or the second wall side, or transverse to the first direction and/or the second direction, and the mean width is transverse to the first wall side and/or the second wall side, or aligned with the first direction and/or the second direction, wherein the mean heigh is greater than the mean width. For example, the mean height may be 5 to 25 times, or 10 to 20 times, greater than the mean width. Worded differently, the first conduit section may have two opposed wide sides and two opposed narrow sides, wherein the wide sides of the first conduit section are aligned with the first wall side and/or the second wall side, or face in the first direction and/or second direction. It is understood that the wide sides and the narrow sides of the first conduit section jointly outlines the cross-section of the first conduit section transverse to the first flow direction. The two opposed wide sides of the first conduit section sides may be planar and parallel. For example, the wide sides may be 5 to 25 times, or 10 to 20 times, wider than the narrow sides transverse to the first flow direction.

Each of the second conduit sections may be jointly formed by the first wall and one of the transistor power modules. The power converter unit, or the first wall, may comprise one or more gaskets, wherein each gasket seals one of the transistor power modules to the first wall. It is understood that the gasket is arranged to prevent a coolant to pass between the transistor power module and the first wall. It is specified above that the first transistor arrangement may have a plurality of transistor power modules. It is understood that the first coolant conduit then has a corresponding plurality of second conduit sections.

It is specified above that the transistor heatsink of each transistor power module may have protrusions extending into the first coolant conduit, and that each transistor power module may have a heatsink base from which the protrusions extend. For each second conduit section jointly formed by the first wall and one of the one or more transistor power modules, the second conduit section may have two opposed wide sides and two opposed narrow sides. One of the wide sides is formed by the transistor power modules, by the transistor heatsink of the transistor power module, or by the heatsink base of the of the transistor heatsink of the transistor power module. The other wide side may be formed by the first wall. This contributes to a more compact power converter unit. The wide sides of the second conduit section may be aligned with the first wall side and/or the second wall side, or face in the first direction and/or second direction. It is understood that the wide sides and the narrow sides the second conduit section jointly outlines the cross-section of the second conduit section transverse to the second flow direction. The two opposed wide sides of the second conduit section sides may be planar and parallel. The second conduit section may be elongated in the second flow direction.

The protrusions of the transistor heatsink may extend from the heatsink base of the transistor heatsink towards the first wall. The protrusions may extend transverse to the second flow direction. The protrusions may extend transverse to the two opposed wide of the second conduit section sides. It is specified that the protrusions may be pins. The tip of each pin may be positioned at the first wall. The tip may be spaced apart from the first wall. Alternatively, the tip may contact the first wall.

The transistor heatsink of the transistor power module may outline a rectangle having a pair of opposed first edges and a pair of opposed second edges. The first edges may be longer than the second edges. Worded differently, the first edges may be long edges and the second edges may be short edges. The first edges may be aligned with the second flow direction. This means that the second edges are transverse to the second flow direction.

Each second conduit section may have a first aperture that connects the first conduit section and the second conduit section and second aperture that connects the second conduit section and the third conduit section. It is understood that the first aperture and the second aperture are arranged to allow the coolant to flow from the first conduit section to the third conduit section, or vice versa, via the second conduit section. It is further understood that each of the first aperture and the second aperture may be formed by the first wall.

The first aperture may be elongated. Similarly, the second aperture may be elongated. The first aperture may be aligned with the first flow direction through the first conduit section. The first aperture may be transverse to the second flow direction in the second conduit section. The second aperture may be transverse to the second flow direction in the second conduit section. The second aperture may be aligned with the third flow direction through the third conduit section. The elongated first aperture and second aperture may extend in parallel.

The first aperture and the second aperture may be aligned with the opposed second edges of the rectangle outlined by the transistor heatsink. The first aperture may be located at one of the second edges and the second aperture may be located at the other second edge. It is specified that the second conduit section may have two opposed wide sides and two opposed narrow sides. Each of the first aperture and the second aperture may extend from one of the wide sides to the other wide side. Worded differently, each of the first aperture and the second aperture may extend across the complete width between the two opposed wide sides.

The one or more second conduit sections may be arranged to restrict a flow of the coolant through the first coolant conduit. For example, the abovementioned protrusions of the transistor heatsinks may restrict the flow. Additionally or alternatively, the first aperture and/or the second aperture may restrict the flow. If there is a plurality of second conduit sections, this contributes to evenly distribute the flow of the coolant between them.

The third conduit section may at least in part be formed by the first wall. Worded differently, the third conduit section may in part be formed by the first wall, or the complete third conduit section may be formed by the first wall. The third conduit section may be elongated in the third flow direction.

The power converter unit may further comprise: a second transistor arrangement, and a second capacitor arrangement. The support structure is arranged to at least partly support the second transistor arrangement and the second capacitor arrangement. The support structure has a second wall, and the second transistor arrangement and the second capacitor arrangement are located on opposite sides of the second wall. The second capacitor arrangement is thermally coupled to, or in thermal connection with, the second wall, and the second wall forms a capacitor heatsink for the second capacitor arrangement. The second transistor arrangement comprises one or more transistor power modules, and each transistor power module has a transistor heatsink, the support structure has a second coolant conduit at least partly formed by the second wall. The second coolant conduit is arranged to expose the capacitor heat sink formed by the second wall to a coolant and to expose the transistor heatsink of each transistor power module of the second transistor arrangement to a coolant. The first capacitor arrangement and the second capacitor arrangement are located between the first wall and the second wall. The support structure may be arranged to fully support the second transistor arrangement and the second capacitor arrangement.

The first wall and the second wall may be aligned and positioned abreast. The second capacitor arrangement may be positioned at, or juxtaposed to, the first capacitor arrangement. The first capacitor arrangement and the second capacitor arrangement may be located between the first transistor arrangement and the second transistor arrangement. It is understood that the first wall and the second wall are spaced apart to allow the first capacitor arrangement and the second capacitor arrangement to be located between them.

It is understood that the second wall has a first wall side, or outer side, and an opposite second wall side, or inner side. The first wall side of the first wall and the first wall side of the second wall may face in opposite direction. Similarly, the second wall side of the first wall and the second wall side of the second wall may face in opposite direction. Worded differently, the first wall side faces of the second wall faces may face in the second direction and that the second wall side of the second wall may face in the opposite first direction.

It is specified that the first transistor arrangement may be located on the first wall side of the first wall and the first capacitor arrangement may be located on the second wall side of the first wall. Similarly, the second transistor arrangement may be located on the first wall side of the second wall and the second capacitor arrangement may be located on the second wall side of the second wall. Worded differently, the first wall and the second wall may be located between the first transistor arrangement and the second transistor arrangement.

The first transistor arrangement and the second transistor arrangement may comprise the same number of transistor power modules. The first capacitor arrangement and the second capacitor arrangement may comprise the same number of capacitors. The first transistor arrangement may comprise three transistor power modules arranged to cooperate and generate a first three-phase AC. Similarly, the second transistor arrangement may comprise three transistor power modules arranged to cooperate and generate a second three-phase AC that is independent from the first three-phase AC. More generally, the first transistor arrangement may be arranged to generate a first AC and the second transistor arrangement may be arranged to generate a second AC that is independent from the first AC. Alternatively, the first transistor arrangement may comprise three transistor power modules, the second transistor arrangement may comprise three transistor power modules, and the first transistor arrangement and the second transistor arrangement may be arranged to cooperate and generate a six-phase AC. More generally, the first transistor arrangement and the second transistor arrangement may be arranged to generate a single AC.

The first capacitor arrangement and the second capacitor arrangement may be disconnected from one another. Alternatively, the first capacitor arrangement and the second capacitor arrangement may be operationally coupled to jointly function as a single capacitor, for example in a parallel circuit.

The second transistor arrangement, second capacitor arrangement, second wall, and second coolant conduit may be arranged in a mirror symmetry relative to the first transistor arrangement, first capacitor arrangement, first wall, and first coolant conduit. The mirror symmetry may be with respect to a symmetry plane between the first capacitor arrangement and the second capacitor arrangement. It is understood that the symmetry plane is parallel to the first wall and the second wall, or transverse to the first direction and the second direction.

The second transistor arrangement, second capacitor arrangement, second wall, and second coolant conduit may be arranged as and/or may comprise any of the features described above for the first transistor arrangement, first capacitor arrangement, first wall, and first coolant conduit. For example, the second coolant conduit may have a first conduit section, one or more second conduit sections, and a third conduit section, that are arranged as and/or comprise any of the features described above.

It is specified that the second capacitor arrangement is thermally coupled to the second wall. The power converter unit may further comprise a second thermal conductor arranged to conduct heat from the second capacitor arrangement to the second wall, or more precisely to the capacitor heatsink formed by the second wall. The second thermal conductor may be arranged as and/or may comprise any of the features of the first thermal conductor.

It is specified that the first wall and the second wall may be of metal. The complete support structure may be of metal, such as an aluminum alloy. The support structure may have, or form, unitary structure, or monolithic structure. For example, the unitary structure may be machined from a single piece of material. This means that it has not been assembled from several parts. This contributes to reduce the risk of leakage from the first coolant conduit and the second coolant conduit. The first wall and the second wall may form part of the unitary structure of the support structure.

It is specified that the first wall and the second wall may be aligned and positioned abreast. The support structure may have a third wall that is connected to the first wall and the second wall. The third wall may be transverse to the first wall and the second wall. The third wall may form part of the unitary structure of the support structure. The support structure may have a base, or bottom, connected to the first wall and the second wall. The base may be transverse to the first wall and the second wall. The first wall and the second wall may be at opposite sides of the base. The base may be connected to the third wall. The base may be transverse to the third wall. The base may form part of the unitary structure of the support structure. The support structure may comprise a fourth wall. The fourth wall may be connected to the first wall and the second wall. The fourth wall may be connected to the base. The third wall and the fourth wall may be at opposite sides of the base. The fourth wall may form part of the unitary structure of the support structure. If an element forms part of a unitary structure, it is understood that the element may have further components that are not part of the unitary structure.

The first wall, second wall, third wall, fourth wall, and base may define an interior space that has an open end at the opposite side of the interior space relative to the base. It is understood the first capacitor arrangement and the second capacitor arrangement are located in the interior space, and that the open end allows for the first capacitor arrangement and the second capacitor arrangement to be positioned within the interior space.

The support structure may outline a cuboid. More specifically the first wall, second wall, third wall, fourth wall, and base may outline five sides of a rectangular cuboid. It is understood that the first wall and the second wall outline opposite sides of the rectangular cuboid, and that the third wall and the fourth wall outline opposite sides of the rectangular cuboid.

The third conduit sections may be located closer to the base than the first conduit sections. The third conduit sections may in part be formed by the base.

The support structure may form a first manifold connected to the first coolant conduit and the second coolant conduit. It is understood that the first manifold is arranged to distribute a coolant to or collect a coolant from the first coolant conduit and the second coolant conduit. More specifically, the support structure may form a first manifold connected to the first conduit section of the first coolant conduit and the to the first conduit section of the second coolant conduit. It is understood that the first manifold is arranged to distribute a coolant to or collect a coolant from the first conduit sections. The first manifold may be formed by the third wall.

The support structure may form a second manifold connected to the first coolant conduit and the second coolant conduit, wherein each of the first coolant conduit and the second coolant conduit extend independently from one another between the first manifold and the second manifold. It is understood that the second manifold is arranged to distribute a coolant to or collect a coolant from the first coolant conduit and the second coolant conduit. More specifically, the support structure may form a second manifold connected to the third conduit section of the first coolant conduit and the to the third conduit section of the second coolant conduit. It is understood that the second manifold is arranged to distribute a coolant to or collect a coolant from the third conduit sections. The second manifold may be formed, or at least in part formed, by the base.

It is specified above that the power converter unit may have an inlet for receiving a coolant and an outlet for dispelling the coolant. The first conduit sections may be coupled to the inlet via the first manifold and the third conduit section may be coupled to the outlet via the second manifold, or the first conduit sections may be coupled to the outlet via the first manifold and the third conduit section may be coupled to the inlet via the second manifold. The inlet and the outlet may be formed by the third wall. Alternatively, the inlet may be formed by the third wall and the outlet may be formed by the fourth wall, or vice versa.

### BRIEF DESCRIPTION OF THE DRAWINGS

A more complete understanding of the abovementioned and other features and advantages of the proposed technology will be apparent from the following detailed description of preferred embodiments of the proposed technology in conjunction with the appended drawings, wherein:
Figs. 1a and 1b are perspective views of a power converter unit,
Figs. 1c and 1d are side views of the power converter unit,
Fig. 2 is a perspective view of the support structure of the power converter unit,
Figs. 3a to 3d are different cross-sectional views of the power converter unit.

### DETAILED DESCRIPTION OF THE DRAWINGS

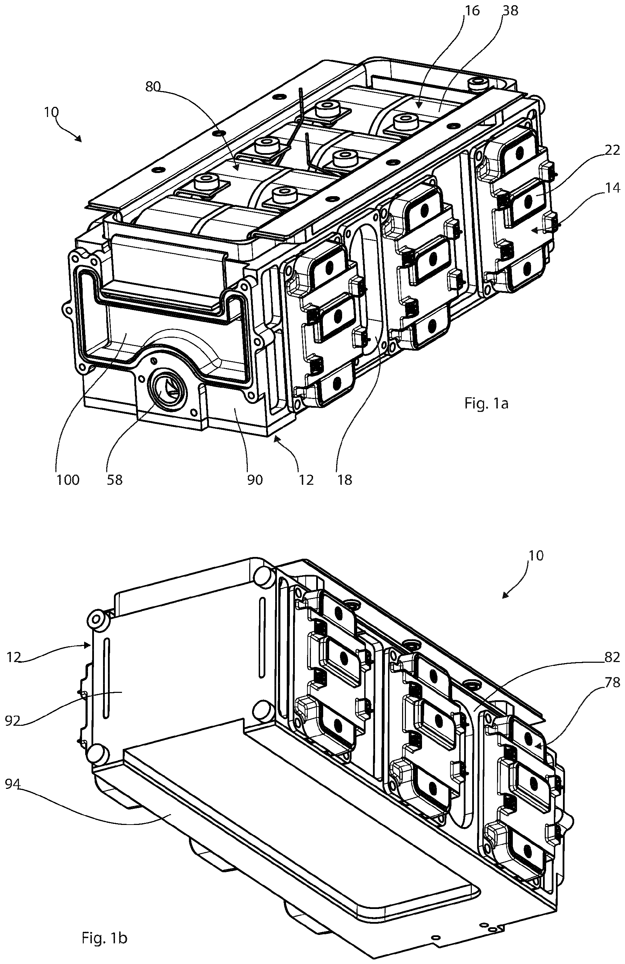

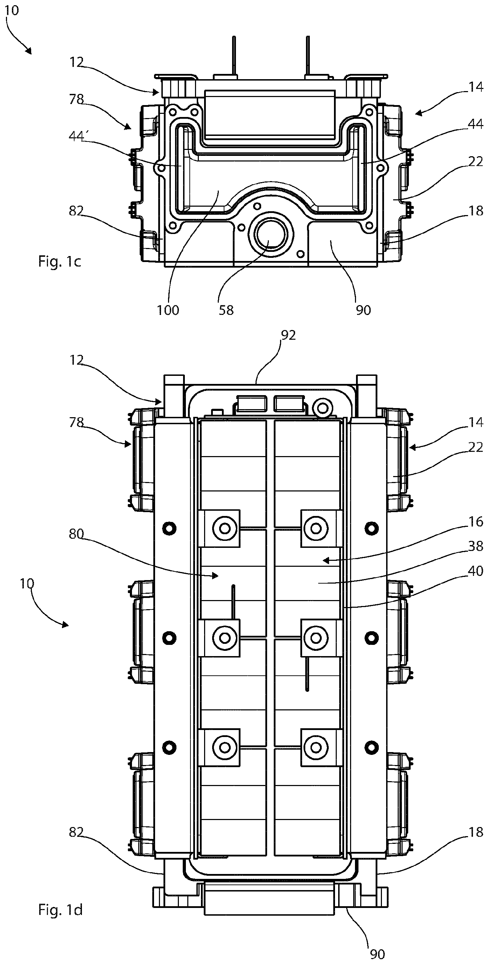

**Figs. 1a to 1d** show different views of a static power converter unit 10 that can be arranged to convert DC to and from a first and a second three-phase AC. The power converter unit 10 has a first transistor arrangement 14, a first capacitor arrangement 16, a second transistor arrangement 78, a second capacitor arrangement 80 are that are operationally connected by wires (nots shown) and cooperate in the conversion. The first transistor arrangement 14 and the first capacitor arrangement 16 generate a first three-phase AC, and the second transistor arrangement 78 and the second capacitor arrangement 80 generate a second three-phase AC. In an alternative embodiment, the first transistor arrangement 14, first capacitor arrangement 16, second transistor arrangement 78, and second capacitor arrangement 80 jointly convert DC to and from a six-phase AC.

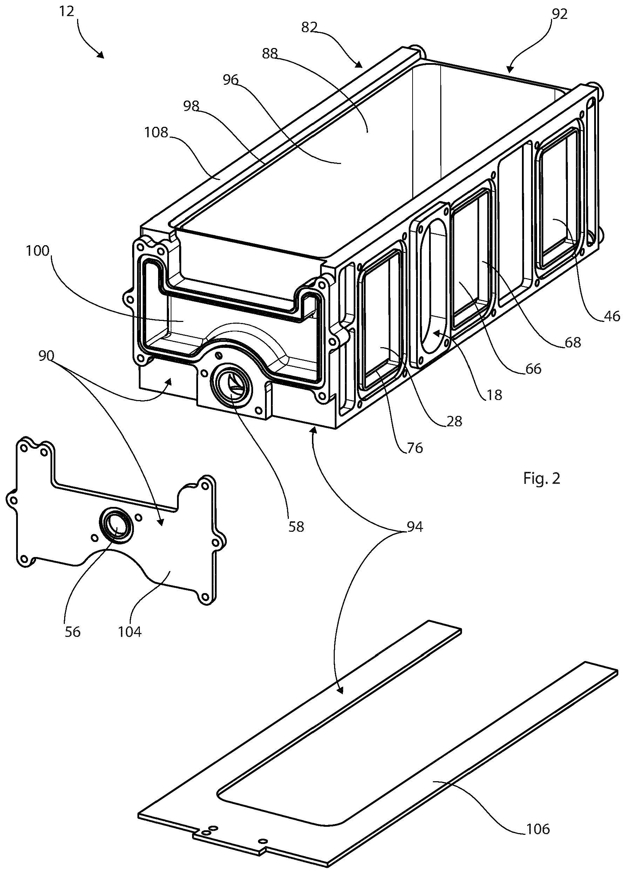

The power converter unit 10 has a support structure 12 made of an aluminum alloy. The power converter unit 10 is shown in Fig. 2 and has a first wall 18 and a second wall 82 that are aligned and positioned abreast. The support structure 12 has a third wall 90 that is connected to and transverse to the first wall 18 and the second wall 82. The support structure 12 has a base 94 connected and transverse to the first wall 18, the second wall 82, and the third wall 90. The first wall 18 and the second wall 82 are positioned at opposite sides of the base 94. The base 94 is also transverse to the third wall 90. The support structure 12 further has a fourth wall 92 connected to the first wall 18, the second wall 82, and the base 94. The third wall 90 and the fourth wall 92 are positioned at opposite sides of the base 94. This way, the first wall 18, second wall 82, third wall 90, fourth wall 92, and base 94 define an interior space 96 that has an open end 98 on the opposite side of the interior space 96 relative to the base 94. Each of the first wall 18, second wall 82, third wall 90, fourth wall 92, and base 94 is a planar structure. This way, the support structure 12 outlines a rectangular cuboid with the first wall 18 and the second wall 82 outlining opposite sides of the rectangular cuboid and that the third wall 90 and the fourth wall 92 outlining opposite sides of the rectangular cuboid.

The first wall 18 has a first wall side 28 that is an outer side and an opposite second wall side 30 that is an inner side. The first wall side 28 faces in a first direction and that the second wall side 30 faces in an opposite second direction. Similarly, the second wall 82 has a first wall side 86 that is an outer side and an opposite second wall side 88 that is an inner side. This way, the first wall side 28 of the first wall 18 and the first wall side 86 of the second wall 82 face in opposite direction, and the second wall side 30 of the first wall 18 and the second wall side 88 of the second wall 82 face in opposite direction.

The first capacitor arrangement 16 and the second capacitor arrangement 80 are located in the interior space 96, and the open end 98 allows for the first capacitor arrangement 16 and the second capacitor arrangement 80 to be mounted in the interior space 96. The first capacitor arrangement 16 is supported by the first wall 18 and the second capacitor arrangement 80 is supported by the second wall 82. The first capacitor arrangement 16 is positioned at the second wall side 30 of the first wall 18 and the second capacitor arrangement 80 is positioned at the second wall side 88 of the second wall 82. Only the first capacitor arrangement 16 is described in detail, but the second capacitor arrangement 80 shares the features of the first capacitor arrangement 16.

The first capacitor arrangement 16 has eight capacitors 38 arranged in two rows. Each capacitor 38 is a radial-style capacitor and has a cylindrical geometry with a base side facing the first wall 18. The terminals (not shown) of the capacitors 38 that are located at the base side. The first capacitor arrangement 16 has a busbar arrangement 40 located between the capacitors 38 and the first wall 18. The busbar arrangement 40 is a flat structure aligned with the first wall and is composed of several busbars in the form of copper sheets that are located between the capacitors 38 and the first wall 18. The terminals (not shown) of the capacitors 38 are attached to the busbars. The busbar arrangement 40 operationally couples the capacitors 38 in parallel to function as a single capacitor, and the first transistor arrangement 14 is coupled to the first capacitor arrangement 16 via the busbar arrangement 40.

There is a gap 42 between the busbar arrangement 40 and the first wall 18. The gap 42 is filled with a flat first thermal conductor (not shown) in the form of a thermal paste. In an alternative embodiment, the first thermal conductor (not shown) is a thermal pad or a curable thermal gap filler. The first thermal conductor (not shown) is aligned with the first wall 18 and contacts the first wall 18 and the busbar arrangement 40. This way, the first thermal conductor 104 is arranged to conduct heat from the first capacitor arrangement 16 to the first wall 18, and the first capacitor arrangement 16 is thermally coupled to the first wall 18 via the busbar arrangement 40. More specifically, each capacitor 38 is thermally coupled to, or in thermal connection with, the first wall 18. Arranged this way, the first wall 18 forms a capacitor heatsink 20 for the first capacitor arrangement 16. The second wall 82 forms a capacitor heatsink for the second capacitor arrangement 80 in a similar manner.

The first transistor arrangement 14 and the second transistor arrangement 78 are located outside the interior space 96. The first transistor arrangement 14 is supported by the first wall 18 and the second transistor arrangement 78 is supported by the second wall 82.

The first transistor arrangement 14 is positioned at the first wall side 28 of the first wall 18 and the second transistor arrangement 78 is positioned at the first wall side 88 of the second wall 82. This means that the first transistor arrangement 14 and the first capacitor arrangement 16 are located on opposite sides of the first wall 18, and the second transistor arrangement 78 and the second capacitor arrangement 80 are located on opposite sides of the second wall 82. Only the first transistor arrangement 14 is described in detail, but the second transistor arrangement 78 shares the features of the first transistor arrangement 14.

The first transistor arrangement 14 comprises three transistor power modules 22 in the form of power MOSFETs that are arranged in a row and attached to the first wall 18. Each transistor power module 22 has a transistor heatsink 24. Each transistor heatsink 24 has a heatsink base 34 and protrusions 32 in the form of pins that extend from the base 34. Each pin has a tip 36 and the pin extends and tapers from the base 34 to the tip 36. The transistor heatsink 24 of each transistor power module 22 outlines a rectangle having a pair of opposed first edges 70 and a pair of opposed second edges 72 that are shorter than the first edges 70.

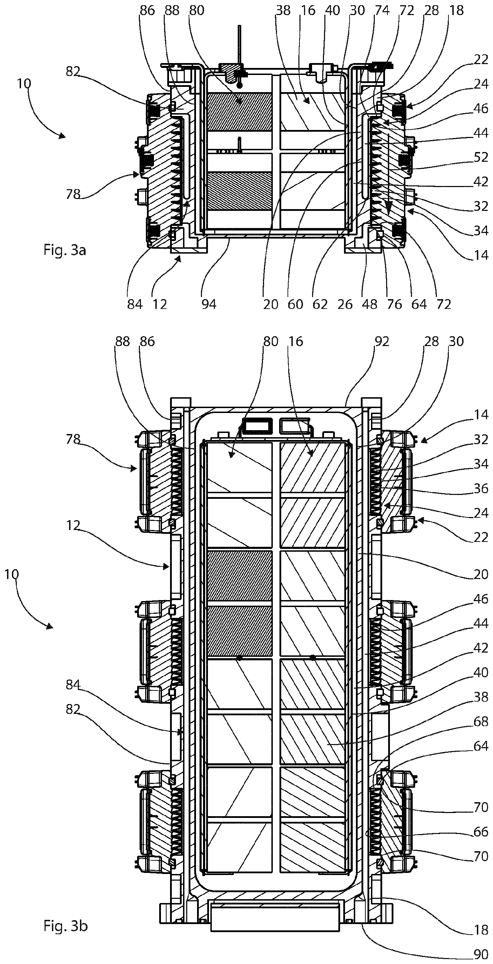

With reference to **Figs. 3a to 3d****,** the support structure 12 has a first coolant conduit 26 formed by the first wall 18 and a second coolant conduit 84 formed by the second wall 82 that can lead a liquid coolant. Only the first coolant conduit 26 is described in detail, but the second coolant conduit 84 shares the features of the first coolant conduit 26.

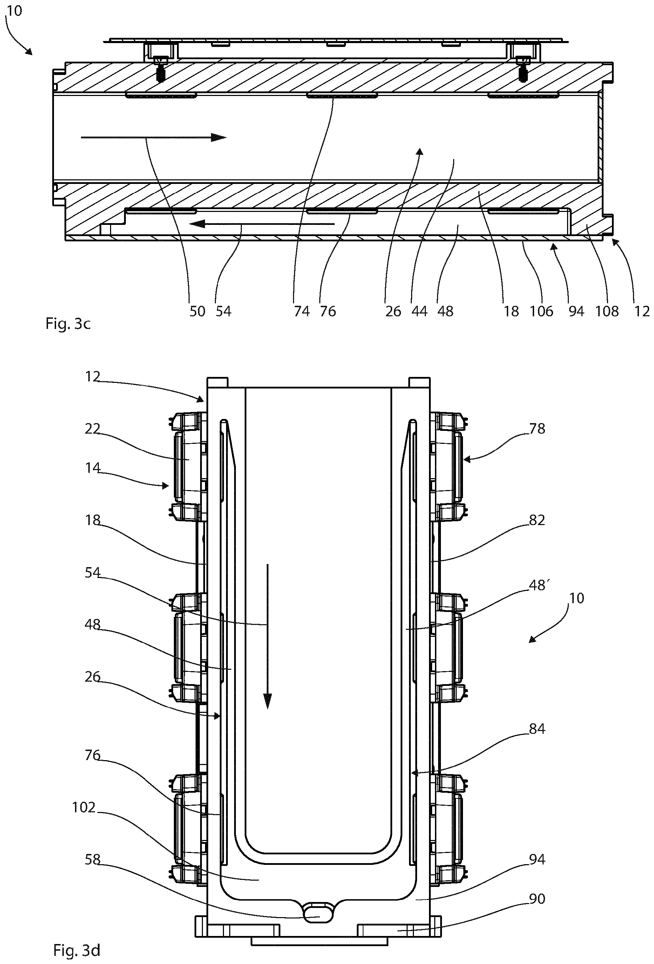

The first coolant conduit 26 has a first conduit section 44, three second conduit sections 46, and a third conduit section 48. The three second conduit sections 46 are connected in parallel to the first conduit section 44 and the third conduit section 48. The first coolant conduit 26 can lead the coolant in a first flow direction 50 indicated by an arrow in **Fig. 3c****,** the second conduit sections 46 can lead the coolant in a second flow direction 52 indicated by an arrow in **Fig. 3a****,** and the third conduit section 48 can lead the coolant in a third flow direction 54 indicated by arrows in **Figs. 3c and 3d****.** The first conduit section 44 and the third conduit section 48 are elongated and extend in parallel within the first wall 18, and the first flow direction 50 and the third flow direction 54 are opposite. The second flow direction 52 is transverse to both the first flow direction 50 and the second flow direction 52.

The complete first conduit section 44 is formed by the first wall 18. The first conduit section 44 has two opposed wide sides 60 and two opposed narrow sides 62. The wide sides 60 of the first conduit section 44 are planar, parallel, and aligned with the first wall side 28 and the second wall side 30, as can be in **Fig. 3a****.** The first coolant conduit 26 has a mean height and a mean width transverse to the first flow direction 50, and the mean heigh is about fourteen times greater than the mean width. The mean height is aligned with the first wall side 28 and the second wall side 30 and the mean width is transverse to the first wall side 28 and the second wall side 30. This way, the first conduit section 44 is flattened congruently with the first wall 18.

The first conduit section 44 passes between the first transistor arrangement 14 and the first capacitor arrangement 16. The row of transistor power modules 22 and the two rows of capacitors 38 are aligned with the first flow direction 50. This way, the first coolant conduit 26 is arranged to expose the capacitor heat sink 20 formed by the first wall 18 to the coolant. The second coolant conduit 84 is arranged in a similar manner to expose the capacitor heat sink 20 formed by the second wall 82 to the coolant.

Each second conduit section 46 has two opposed wide sides 66 and two opposed narrow sides 68, as shown in the cross section of **Fig. 3b** that is transverse to the second flow direction. One of the wide sides 66 is formed by the heatsink base 34 of one of the transistor power modules 22, and the other wide side 66 is formed by the first wall 18. The first edges 70 of the rectangle outlined by the transistor heatsink 24 are aligned with the second flow direction 52. The wide sides 66 are aligned with the first wall side 28 and the second wall side 30. The two opposed wide sides 66 are planar and parallel. The protrusions 32 of the transistor heatsink 24 extend from the heatsink base 34 towards the first wall 18 transversely to the second flow direction 52, as can be seen in **Fig. 3a****,** and the tip 36 of each protrusion 32 is positioned at and spaced apart from the wide side 66 formed by the first wall 18. With the architecture described here, each of the second conduit sections 46 are jointly formed by the first wall 18 and one of the one or more transistor power modules 22.

Each second conduit section 46 has an elongated first aperture 74 formed by the first wall 18 that connects the first conduit section 44 and the second conduit section 46. It further has an elongated second aperture 76 formed by the first wall 18 that connects the second conduit section 46 and the third conduit section 48. This way, the coolant can flow between the first conduit section 44 to the third conduit section 48 via the second conduit section 46. The first aperture 74 is aligned with the first flow direction 50, the second aperture 76 is aligned with the third flow direction 54, and both apertures 74 and 76 are transverse to the second flow direction 52. The first aperture 74 is aligned with and located at one of the second edges 72 of the rectangle outlined by the transistor heatsink 24, and the second aperture 76 is aligned with and located at the other second edge 72 of the rectangle outlined by the transistor heatsink 24. Both the first aperture 74 and the second aperture 76 extend across the complete width between the two opposed wide sides 66 of the second conduit section 46. The first aperture 74, the second aperture 76, and the protrusions 32 of the transistor heatsink 24 jointly restrict the flow of the coolant through second conduit section 46.

Each of the transistor power modules 22 is sealed to the first wall 18 by a gasket 64. Arranged this way, each of the second conduit sections 46 is jointly formed by the first wall 18 and one of the transistor power modules 22, and the protrusions 32 of the heatsink 24 of the transistor power module 22 extend into the first coolant conduit 26, or more specifically the second conduit sections 46, and the coolant can flow transverse to the protrusions 32, and the first coolant conduit 26 is arranged to expose the transistor heatsink 24 of each transistor power module 22 of the first transistor arrangement 14 to the coolant. The second coolant conduit 84 is arranged in a similar manner to expose the transistor heatsink 24 of each transistor power module 22 of the second transistor arrangement 78 to the coolant.

The third conduit section is formed by the first wall 18 and the base 94. This means that the third conduit section 48 is located closer to the base 94 than the first conduit section 44.

The second capacitor arrangement 80 is positioned at the first capacitor arrangement 16, and the first capacitor arrangement 16 and the second capacitor arrangement 80 are located between the first transistor arrangement 14 and the second transistor arrangement 78. The power converter unit 10 has a symmetry plane (not shown) between the first capacitor arrangement 16 and the second capacitor arrangement 80 that is parallel to the first wall 18 and the second wall 82. The second transistor arrangement 78, second capacitor arrangement 80, second wall 82, and second coolant conduit 84 are arranged in a mirror symmetry relative to the first transistor arrangement 14, first capacitor arrangement 16, first wall 18, and first coolant conduit 26. The second transistor arrangement 78, second capacitor arrangement 80, second wall 82, and second coolant conduit 84 are arranged as and shares the features of the first transistor arrangement 14, first capacitor arrangement 16, first wall 18, and first coolant conduit 26.

There is also a gap between second wall 82 and the busbar arrangement of the second capacitor arrangement 80, and the gap is filled with a flat second thermal conductor (not shown) in the form of a thermal paste.

The support structure 12 is a three-part structure, as shown in **Fig. 2****.** It has a unitary structure 108 forming the first wall 18, second wall 82, and fourth wall 92. The third wall 90 is jointly formed by the unitary structure 108 and a side plate 104 attached and sealed to the unitary structure 108, and the base 94 is jointly formed by the unitary structure 108 and a base plate 106 attached and sealed to the unitary structure 108. The unitary structure, side plate 104, and base plate 108 are of an aluminum alloy.

The third wall 90 forms a first manifold 100 connected to the first conduit section 44 of the first coolant conduit 26 and the to the first conduit section 44' of the second coolant conduit 84, as shown in **Fig. 1c****.** The side plate 104 of the third wall 90 forms an inlet 56, and the first conduit sections 44 and 44' of the first coolant conduit 26 and the second coolant conduit 84 are coupled to the inlet 56 via the first manifold 100. The base 94 forms a second manifold 102 connected to the third conduit section 48 of the first coolant conduit 26 and the to the third conduit section 48' of the second coolant conduit 84, as shown in **Fig. 3d****.** The third wall 90 forms an outlet 58, and the third conduit sections 48 and 48' of the first coolant conduit 26 and the second coolant conduit 84 are coupled to the outlet 58 via the second manifold 102.

### ITEM LIST

10 power converter unit
12 support structure
14 first transistor arrangement
16 first capacitor arrangement
18 first wall
20 capacitor heatsink
22 transistor power module
24 transistor heatsink
26 first coolant conduit
28 first wall side of first wall
30 second wall side of first wall
32 protrusions
34 heatsink base
36 tip
38 capacitor
40 busbar arrangement
42 gap
44 first conduit section
46 second conduit section
48 third conduit section
50 first flow direction
52 second flow direction
54 third flow direction
56 inlet
58 outlet
60 wide side of first conduit section
62 narrow side of first conduit section
64 gasket
66 wide side of second conduit section
68 narrow side of second conduit section
70 first edge of transistor heat sink
72 second edge of transistor heat sink
74 first aperture
76 second aperture
78 second transistor arrangement
80 second capacitor arrangement
82 second wall
84 second coolant conduit
86 first wall side of second wall
88 second wall side of second wall
90 third wall
92 fourth wall
94 base
96 interior space
98 open end
100 first manifold
102 second manifold
104 side plate
106 base plate
108 unitary structure

## Claims

1. A power converter unit (10) comprising:
- a support structure (12),
- a first transistor arrangement (14), and
- a first capacitor arrangement (16), wherein
the support structure (12) is arranged to at least partly support the first transistor arrangement (14) and the first capacitor arrangement, the support structure (12) has a first wall (18), and the first transistor arrangement (14) and the first capacitor arrangement (16) are located on opposite sides of the first wall (18),
the first capacitor arrangement (16) is thermally coupled to the first wall (18), and the first wall (18) forms a capacitor heatsink (20) for the first capacitor arrangement (16),
the first transistor arrangement (14) comprises one or more transistor power modules (22) and each transistor power module (22) has a transistor heatsink (24),
the support structure (12) has a first coolant conduit (26) at least partly formed by the first wall (18), the first coolant conduit (26) is arranged to expose the capacitor heat sink formed by the first wall (18) to a coolant and to expose the transistor heatsink (24) of each transistor power module (22) of the first transistor arrangement (14) to a coolant.

2. The power converter unit (10) according to claim 1, wherein the first coolant conduit (26) passes between the first transistor arrangement (14) and the first capacitor arrangement (16).

3. The power converter unit (10) according to claim 1 or 2, wherein the transistor heatsink (24) of each transistor power module (22) has protrusions (32) extending into the first coolant conduit (26).

4. The power converter unit (10) according to any of the claims 1 to 3, wherein the first capacitor arrangement (16) comprises a plurality of capacitors (38) and a busbar arrangement (40) located between the capacitors (38) and the first wall (18), and the plurality of capacitors (38) are thermally coupled to the first wall (18) via the busbar arrangement (40).

5. The power converter unit (10) according to any of the claims 1 to 4, wherein the first coolant conduit (26) has a first conduit section (44), one or more second conduit sections (46), and a third conduit section (48), each of the second conduit sections (46) connects the first conduit section (44) and the third conduit section (48), the first coolant conduit (26) is arranged to lead the coolant through the first conduit section (44) in a first flow direction (50), through the one or more second conduit sections (46) in a second flow direction (52), and through the third conduit section (48) in a third flow direction (54), and the first flow direction (50) and the third flow direction (54) are parallel.

6. The power converter unit (10) according to claim 5, wherein the second flow direction (52) is transverse to the first flow direction (50) and/or the second flow direction (52).

7. The power converter unit (10) according to claim 5 or 6, wherein the first conduit section (44) passes between the first a first transistor arrangement (14) and the first capacitor arrangement (16).

8. The power converter unit (10) according to any of the claims 5 to 7, wherein the first conduit section (44) is flattened congruently with the first wall (18).

9. The power converter unit (10) according to any of the claims 5 to 8, wherein each of the second conduit sections (46) are jointly formed by the first wall (18) and one of the one or more transistor power modules (22).

10. The power converter unit (10) according to any of the claims 5 to 9, wherein each second conduit section has a first aperture (74) that connects the first conduit section (44) and the second conduit section and a second aperture (76) that connects the second conduit section and the third conduit section (48), the first aperture (74) is elongated and aligned with the first flow direction (50), and the second aperture (76) is elongated aligned with the third flow direction (54).

11. The power converter unit (10) according to any of the claims 1 to 10, wherein the power converter unit (10) further comprises:
- a second transistor arrangement (78), and
- a second capacitor arrangement (80), wherein
the support structure (12) is arranged to at least partly support the second transistor arrangement (78) and the second capacitor arrangement (80), the support structure (12) has a second wall (82), and the second transistor arrangement (78) and the second capacitor arrangement (80) are located on opposite sides of the second wall (82),
the second capacitor arrangement (80) is thermally coupled to the second wall (82), and the second wall (82) forms a capacitor heatsink for the second capacitor arrangement (80),
the second transistor arrangement (78) comprises one or more transistor power modules, and each transistor power module has a transistor heatsink,
the support structure (12) has a second coolant conduit (84) at least partly formed by the second wall (82), the second coolant conduit (84) is arranged to expose the capacitor heat sink formed by the second wall (82) to a coolant and to expose the transistor heatsink of each transistor power module of the second transistor arrangement (78) to a coolant, and
the first capacitor arrangement (16) and the second capacitor arrangement (80) are located between the first wall (18) and the second wall (82).

12. The power converter unit (10) according to claim 11, wherein the first wall (18) and the second wall (82) are located between the first transistor arrangement (14) and the second transistor arrangement (78).

13. The power converter unit (10) according to claim 11 or 12, wherein the second transistor arrangement (78), second capacitor arrangement (80), second wall (82), and second coolant conduit (84) are arranged in a mirror symmetry relative to the first transistor arrangement (14), first capacitor arrangement (16), first wall (18), and first coolant conduit (26).

14. The power converter unit (10) according to any of the claims 11 to 13, wherein the support structure (12) forms a first manifold (100) connected to the first coolant conduit (26) and the second coolant conduit (84).

15. The power converter unit (10) according to claim 14, wherein the support structure (12) forms a second manifold (102) connected to the first coolant conduit (26) and the second coolant conduit (84), and each of the first coolant conduit (26) and the second coolant conduit (84) extends independently from one another between the first manifold (100) and the second manifold (102).
